Europäisches Patentamt

European Patent Office

Office européen des brevets

(11) Publication number: **0 018 404 B1**

# EUROPEAN PATENT SPECIFICATION

(45) Date of publication of patent specification: **11.03.92**

(51) Int. Cl.5: **G06F 9/22**, G06F 13/00, G11C 17/00, G05B 19/04

(21) Application number: **79900872.7**

(22) Date of filing: **08.08.79**

(86) International application number: **PCT/GB79/00136**

(87) International publication number: **WO 80/00383 (06.03.80 80/05)**

(54) MEMORY SYSTEM FOR PROGRAMMABLE CONTROLLER.

(30) Priority: **12.08.78 GB 3315078**

(43) Date of publication of application: **12.11.80 Bulletin 80/23**

(45) Publication of the grant of the patent: **11.03.92 Bulletin 92/11**

(84) Designated Contracting States: **CH DE FR GB NL SE**

(56) References cited:
**DE-A- 2 546 713**
**FR-A- 2 152 564**
**FR-A- 2 268 304**
**FR-A- 2 291 547**

(73) Proprietor: **SOUARE D COMPANY Executive Plaza Palatine, IL 60067(US)**

(72) Inventor: **HIGGINS, Leslie John 21 Clifton Street Swindon, Wiltshire(GB)**

(74) Representative: **Sorrell, Terence Gordon et al Fitzpatricks 4 West Regent Street Glasgow G2 1RS Scotland(GB)**

Procedings of the sixth international Congress of Microelectronics. Documentation, Munich, 25-27 November 1974, published by Oldenbourg Verlag, Munich (DE) 8 pages,Weissberger:"User Microprogram Development for an LSI Processor", see page 5, first paragraph and from page 3, 4th paragraph to page 4, 2nd paragraph

Electronics, April 26, 1973, New-York (US) pages 116-119, Townsend:"Overlaid Memory simplifies programs has hidden nooks for diagnostics", see page 117, right-hand column, 3rd paragraph and page 118, left-hand colum, 2nd and 3rd paragraphs

MIcroprocessors and microsystems, December 1978, pages 350 to 351, Londen (GB) Godliman:"Using EPROMs for file storage", see page 351, left-hand colomn, last paragraph

## Description

This invention relates to a memory arrangement for a programmable controller.

In a programmable controller the central processor unit receives its control information from a memory in which the programme or programmes are stored. It is normal to prepare the programme off-line and thereafter transfer the programme to the processor memory. Such an arrangement is disclosed in DE-A-2 546 713.

Memories used in programmable controllers can be, amongst others, of the random access type (RAM) or can be the electrically alterable read only type (EAROM). The former type has the advantage of relatively fast write and erase times but requires a power source in order that the information is retained. The EAROM memory is non-volatile i.e. no back-up batteries are required but suffers from the disadvantage that it has slow write and erase times when compared with the RAM memory. Thus, in programmable controllers which employ EAROM memories the facility for programming "on the fly" i.e. when the system is in use, is not available.

It is an object of the present invention to obviate or mitigate this advantage.

According to one aspect of the present invention there is provided a programmable controller comprising a central processor unit operable under control of program information held in a memory in which the memory comprises a fast random access memory (RAM) and a slow read-only memory of electrically-alterable type (EAROM); characterised in that the RAM and EAROM are connected in parallel to the central processor unit, the central processor unit can operate under the control of either the RAM or the EAROM selectively, and means are provided for transferring data between the RAM and EAROM independently of the central processor unit.

According to a further aspect of the invention there is provided a method of operating a programmable controller having a central processor unit operating under the control of program information held in a memory in the form of a fast random access memory RAM and a slow read-only memory of electrically-alterable type (EAROM); characterised by holding the program information in the EAROM for normal operation, loading new program information when desired into the RAM, transferring control of the processor unit to the RAM, transferring the new program information to the EAROM while control remains with the RAM, and subsequently returning control to the EAROM.

Embodiments of the present invention will now be described, by way of example, with reference to the accompanying drawings, in which:

Fig. 1 - is a block diagram of one memory arrangement according to the present invention;
Fig. 2 - is a detailed circuit diagram of the EAROM memory part of a memory arrangement according to the present invention; and
Fig. 3 - is a circuit diagram of the RAM memory part of a memory arrangement according to the present invention.

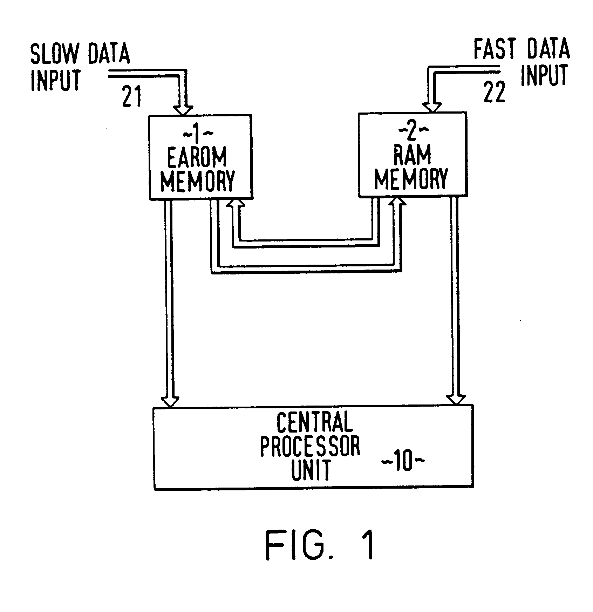

Referring to Fig. 1 a memory arrangement for a programmable controller comprises a first memory 1 of the electrically alterable read only type (EAROM) which contains a system programme which is fed to a central processor unit 10 of the programmable controller. New input data can be supplied to the memory 1 through a data bus 21. In view of the relatively slow write and erase times of the EAROM memory 1 the data bus 21 is termed a slow data input.

A second memory 2 of the random access type (RAM) is provided and adapted to receive new programme or data through a data bus 22. The data bus 22 can be referred to as a fast data input in view of the relatively fast write and erase times of the RAM memory 2. The second memory 2 is connected to the first memory 1 so that the programme contained in the first memory can be substituted by the programme in the second memory 2. The second memory 2 is also connected to the central processor unit 10 and the programme in the second memory may also control the central processor, the first memory being at that time disabled or disconnected from the processor unit.

The second memory 2 being of the RAM type has relatively fast write and erase times and any alteration of the programme may be effected by entering data through the bus 22.

The inclusion of the second memory 2 of the RAM type allows a new programme to be inserted in the system whilst the system is operating under control of the first memory 1. Once the new programme has been inserted in the RAM memory 2 the processor can be controlled from this memory and simultaneously the new programme can be transferred to the EAROM memory 1. Additionally, the existing programme can be passed from the EAROM memory to the RAM memory for amendment whilst the processor is under the control of the memory 1.

Further, the arrangement of this invention allows the programme to be duplicated on to a number of EAROM memories which, because of their non-volatile nature, can be transferred to other systems without loss of information.

Still further, the above arrangement allows a number of new programmes to be tested without disturbing the existing system programme. This is effected by entering a new programme in the RAM memory 2 and controlling the system directly from the RAM memory 2, simultaneously disabling or disconnecting the system EAROM memory 1. After testing of the new or trial programme the system is returned to being controlled by the original programme in the EAROM memory 1.

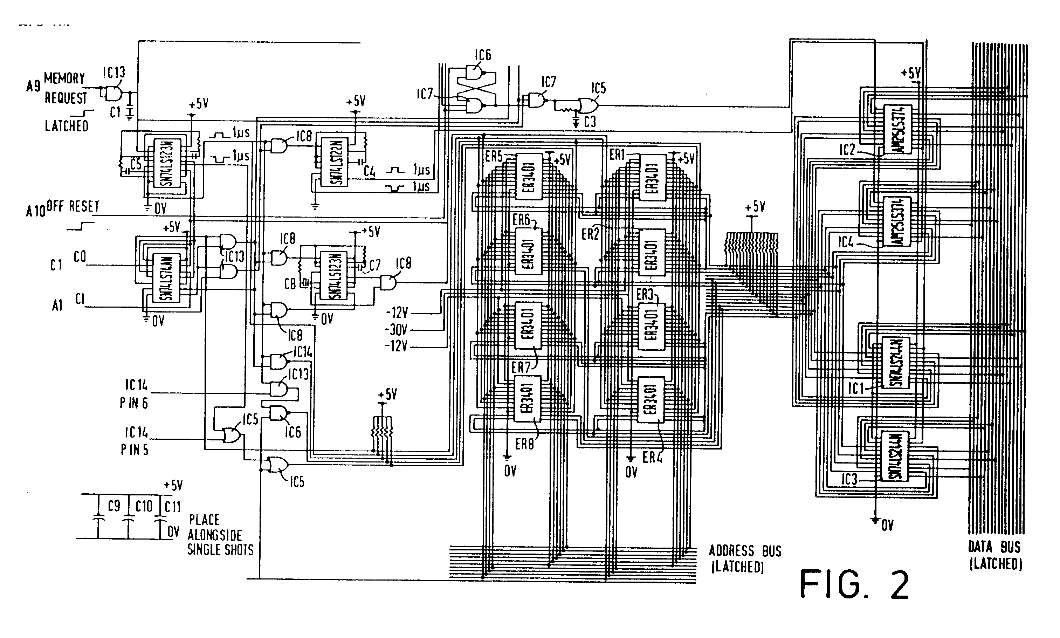

Fig. 2 is a detailed circuit diagram the EAROM memory part of a memory arrangement of the present invention for application to a programmable controller.

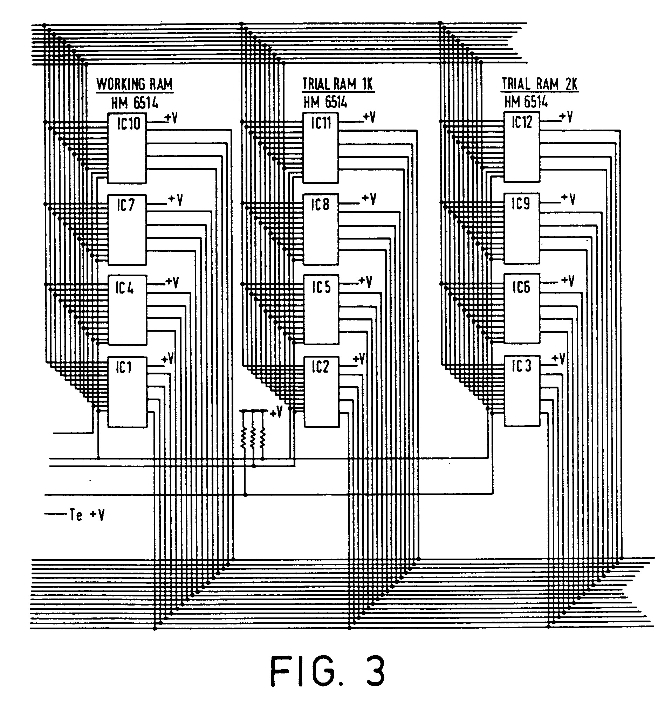

Fig. 3 is a detailed circuit diagram of the RAM memory part of a memory arrangement of the present invention for application to a programmable controller.

## Claims

1.  A programmable controller comprising a central processor unit (10) operable under control of program information held in a memory (1, 2), in which the memory comprises a fast random access memory (RAM) (2) and a slow read-only memory of electrically-alterable type (EAROM) (1); characterised in that the RAM (2) and EAROM (1) are connected in parallel to the central processor unit (10), the central processor unit (10) can operate under the control of either the RAM (2) or the EAROM (1) selectively, and means are provided for transferring data between the RAM (2) and EAROM (1) independently of the central processor unit (10).

2.  A programmable controller as claimed in claim 1 characterised in that the central processor unit (10) is arranged to operate under control of the RAM (2) whilst a program is simultaneously being transferred to the EAROM (1) from the RAM (2).

3.  A method of operating a programmable controller having a central processor unit (10) operating under the control of program information held in a memory (1, 2) in the form of a fast random access memory RAM (2) and a slow read-only memory of electrically-alterable type (EAROM) (1); characterised by holding the program information in the EAROM (1) for normal operation, loading new program information when desired into the RAM (2), transferring control of the processor unit (10) to the RAM (2), transferring the new program information to the EAROM (1) while control remains with the RAM (2), and subsequently returning control to the EAROM (1).

## Revendications

1.  Régisseur programmable comprenant une unité centrale de processeur (10) fonctionnant sous la commande d'informations de programme contenues dans une mémoire (1, 2), dans lequel la mémoire comprend une mémoire vive rapide (RAM) (2) et une mémoire morte lente du type modifiable électriquement (EAROM) (1) ;

caractérisé en ce que la RAM (2) et l'EAROM (1) sont branchées en parallèle sur l'unité centrale de processeur (10), en ce que l'unité centrale de processeur (10) peut fonctionner sous la commande soit de la RAM (2) soit de l'EAROM (1) au choix, et en ce que des moyens sont prévus pour transférer des données entre la RAM (2) et l'EAROM (1) indépendamment de l'unité centrale de processeur (10).

2.  Régisseur programmable selon la revendication 1, caractérisé en ce que l'unité centrale de processeur (10) est agencée pour fonctionner sous la commande de la RAM (2) tandis qu'un programme est transféré simultanément de la RAM (2) ) à l'EAROM (1).

3.  Procédé pour faire fonctionner un régisser programmable comprenant une unité centrale de processeur (10) fonctionnant sous la commande d'informations de programmes contenus dans une mémoire (1, 2) sous forme d'une mémoire vive rapide (RAM) (2) et d'une mémoire morte lente du type modifiable électriquement (EAROM) (1) ; caractérisé en ce qu'on maintient les informations de programme dans l'EAROM (1) pour le fonctionnement normal, on charge de nouvelles informations de programme dans la RAM (2) si besoin est, on transfère la commande de l'unité centrale (10) à la RAM (2), on transfère les nouvelles informations de programme à l'EAROM (1) tandis que la commande reste dévolue à la RAM (2), et en ce qu'on redonne ensuite la commande à l'EAROM (1).

## Patentansprüche

1.  Programmierbare Steuerung mit einer zentralen Verarbeitungseinheit (CPU) (10), die unter der Kontrolle einer in einem Speicher (1,2) gehaltenen Programminformation arbeitet, wobei der Speicher einen schnellen Speicher mit wahlfreiem Zugriff (RAM) (2) und einen langsamen elektrisch änderbaren Festwertspeicher aufweist (EAROM) (1), dadurch gekennzeichnet, daß der RAM (2) und der EAROM (1) parallel mit der zentralen Verarbeitungseinheit (CPU) (10) verbunden sind, daß die zentrale Verarbeitungseinheit (CPU) (10) wahlweise unter der Kontrolle entweder des RAM (2) oder des EAROM (1) arbeitet, und daß Mittel zur von der zentralen Verarbeitungseinheit (10) unabhängigen Übertragung von Daten zwischen dem RAM (2) und dem EAROM (1) vorgesehen sind.

2. Programmierbare Steuerung nach Anspruch 1, dadurch gekennzeichnet, daß die zentrale Verarbeitungseinheit (CPU) (10) so ausgelegt ist, daß sie unter der Kontrolle des RAM (2) arbeitet, während gleichzeitig ein Programm von dem RAM (2) auf den EAROM (1) übertragen wird.

3. Verfahren zum Betreiben einer programmierbaren Steuerung, die eine zentrale Verarbeitungseinheit (CPU) (10) aufweist, die unter der Kontrolle von Programminformation arbeitet, die in einem Speicher (1, 2) in Gestalt eines schnellen Speichers mit wahlfreiem Zugriff (RAM) (2) und eines langsamen elektrisch änderbaren Festwertspeichers (EAROM) (1) gehalten wird, dadurch gekennzeichnet, daß die Programminformation für den normalen Betrieb in dem EAROM (1) gehalten wird, daß bei Bedarf neue Programminformation in den RAM (2) geladen wird, daß die Kontrolle der Verarbeitungseinheit (CPU) (10) auf den RAM (2) übertragen wird, daß die neue Programminformation auf den EAROM (1) übertragen wird, wobei die Kontrolle bei dem RAM (2) verbleibt, und daß die Kontrolle darauffolgend zu dem EAROM (1) zurückkehrt.

SLOW DATA
INPUT
21

FAST DATA
INPUT
22

~1~
EAROM
MEMORY

~2~
RAM
MEMORY

CENTRAL
PROCESSOR
UNIT ~10~

FIG. 1

FIG. 2

EP 0 018 404 B1

FIG. 3